(19) Europäisches Patentamt
European Patent Office
Office européen des brevets

(11) **EP 4 518 619 A1**

(12) **EUROPEAN PATENT APPLICATION**

(43) Date of publication:
**05.03.2025 Bulletin 2025/10**

(21) Application number: **23194293.9**

(22) Date of filing: **30.08.2023**

(51) International Patent Classification (IPC):
**H10K 10/46** (2023.01)

(52) Cooperative Patent Classification (CPC):
**H10K 10/471**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Technische Universität Dresden**
  **01069 Dresden (DE)**
• **Université Paris-Saclay**
  **91190 Gif sur Yvette (FR)**
• **Centre National de la Recherche Scientifique (CNRS)**
  **75016 Paris (FR)**

(72) Inventors:
• **Kleemann, Hans**
  **01309 Dresden (DE)**
• **Krausse, Jann**
  **01187 Dresden (DE)**
• **Bongartz, Lukas**
  **01099 Dresden (DE)**
• **Leo, Karl**
  **01219 Dresden (DE)**
• **Laurie, Calvet**
  **75016 Paris (FR)**
• **Zonglong, Li**
  **91190 Gif-sur-Yvette (FR)**

(74) Representative: **Kailuweit & Uhlemann**
**Patentanwälte**
**Partnerschaft mbB**
**Bamberger Straße 49**
**01187 Dresden (DE)**

(54) **ORGANIC ELECTROCHEMICAL TRANSISTOR, USE OF IT AND METHOD FOR PRODUCING IT**

(57) The invention refers to an electronic component, in particular an organic electrochemical transistor (OECT) which comprises at least one gate electrode, a source electrode, a drain electrode, a channel and an electrolyte. The electrolyte is a solid electrolyte comprising a polymer, and the channel comprises an organic semiconductor as channel material. The electrolyte has a low water content and/or a low C1-C3-alcohol content as well as a low maximum halogen alkaline salt or alkaline earth or acetate salt content. The invention further refers to the use of this electronic component as a Schmitt-Trigger or a Muller-C-element or a flip-flop or a 1-bit memory. Further, the invention provides a method for forming such an electronic component.

Fig. 1

**Description**

The present invention relates to the construction of an organic electrochemical transistor (OECT), which can be used as a basis for the generation of complex circuit structures and its use, for example, as a Schmitt-Trigger or a Muller-C-element.

To increase the performance efficiency of artificial intelligence systems, the use of tailor-made circuits is essential. It is of great importance that these circuits are not only based on the principles of binary logic and von Neumann architecture, but also allow the effective realization of other computing principles, in particular so-called event-based computing and also stochastic computing. Two important principles are the generation of complex oscillations for the former and probabilistic computation for the latter. Neurons are a typical example of complex oscillators. They integrate an input signal and translate it into an oscillation, which can be used to encode the input information via a variety of different methods (time or rate based). Stochastic computing typically use a random number generator to realize stochastic bitstreams, which can be used to perform a Bayesian inference in hardware using so-called Muller-C-elements, which can they implement Bayes' law.

For all these systems (artificial neurons, Muller-C-elements, random number generators), the state of the art uses conventional circuits that require a large number of transistors to enable a memory function or logic functions. However, the number of transistors and the complex analogue circuit design make such circuits highly susceptible to interference and reduce their power efficiency. Therefore, it is desirable to realize the function of these circuits with the simplest possible components.

The publication "Organic Electrochemical Transistors for Use in Neuromorphic Computing: Boolean and Reversible Logic Gate Solutions" (Perez and Shaheen 2020, [1]) describes, among other things, the design of organic neuron neuromorphisms (ONNs) using "muli-gate organic electrochemical transistors (OECTs)" to emulate Boolean and reversible logic gates.

The paper "Photopatternable solid electrolyte for integrable organic electrochemical transistors: operation and hysteresis" (Weissbach et al. 2022, [2]) presents the development of a solid electrolyte that can be fabricated by standard photolithography techniques and used for integrated organic electrochemical transistors. The solid electrolyte is based on the ionic liquid [EMIM][EtSO4] in a polymer matrix. The described structuring of the electrolyte allows for minimal leakage. The OECTs operated with this solid electrolyte show a hysteresis in the transmission characteristics, for which a quantification method has been developed. In particular, the hysteresis depends on the width of the voltage range traversed at the gate electrode and on the rate of voltage change.

In the study "Thermodynamics of OECTs" (Cucchi et al. 2021, [3]), the "hysteretic" behavior of solid-state OECTs is investigated. It is pointed out that hysteresis is ubiquitous in OECT-IV curves and can be caused by various effects, such as "trap states", "channel charging" with multiple time constants or capacitive currents.

The paper entitled "Threshold Voltage Control in Dual-Gate Organic Electrochemical Transistors" (Tseng et al. 2023, [4]) describes the operation of dual-gate organic electrochemical transistors (OECTs) based on PEDOT: PSS. In this study, it is shown that by using two gates, the threshold voltage of the transistor can be manipulated, allowing more effective control of the transistor. In addition, the study demonstrates the use of dual-gate OECTs for logic circuit design.

The article "Multi-gate organic neuron transistors for spatiotemporal information processing" (Qian and others 2017, [5]) describes the fabrication and performance of multi-gate OECTs that can simulate neuromorphic behaviors such as "dendritically correlated EPSC", "paired pulse facilitation", and modulation.

In "A hybrid living/organic electrochemical transistor based on the Physarum polycephalum cell endowed with both sensing and memristive properties" (Tarabella et al. 2015, [6]), a hybrid bio-organic electrochemical transistor was developed that combines an organic semiconductor layer, poly(3,4-ethylenedioxythiophene) doped with poly(styrene sulfonate), with the Physarum polycephalum cell. The system can operate both as a transistor in a three-point configuration and as a memristive device in a two-point configuration. This combination of functions allows direct monitoring of biochemical processes as well as combining memory and sensing in a single system. The system has been studied through a complete electrical characterization including different gate electrodes.

The article entitled, "Bayesian Inference with Muller C-Elements" (Friedman et al 2016 [7]) describes how Bayesian inference can be performed using a cascade of Muller C-elements based on a CMOS implementation.

The interest and importance of developing new types of Muller C-elements is exemplified in the recent article entitled, "Muller C-Element Exploiting Programmable Metallization Cell for Bayesian Inference" presents a new type of Muller C-element based on a two terminal bipolar device, the so-called programmable metallization cell (PMC) and a CMOS inverter. While the C-element is represented by the PMC and the CMOS inverter, an additional peripheral circuit is needed at each cycle to switch the device between read and write operations.

US 20210341415 A1 describes a transistor comprising a source electrode, a drain electrode, a channel comprising an organic semiconductor material between the source electrode and the drain electrode, a plurality of gate electrodes, and an electrolyte. The electrolyte contacts the gate electrodes and the channel, wherein at least one gate electrode comprises an "oxidoreductase" and at least one other gate electrode does not comprise an "oxidoreductase".

US 10424751 B2 describes an embodiment that may include an electronic device having at least two organic electrochemical transistors (OECTs). A respective OECT includes a conductive channel, a gate electrically connected to the conductive channel via a first electrolyte, and a source and a drain electrode separated from each other by the conductive channel. The electrochemical potentials of the "redox couple" of the at least two organic electrochemical transistors are different, resulting in the at least two organic electrochemical transistors having different threshold voltages. Furthermore, they disclose the possibility that the threshold voltage of the OECTs is adjustable, e.g. by selecting different gate materials. In addition to the single-transistor oscillator that can be used to interrogate sensors in a sensor network, other types of low-voltage circuit components can be implemented using adjustable-voltage OECTs. For example, a logic gate (e.g., inverter, AND gate, NAND gate, etc.) can be constructed with a number of OECT transistors.

EP 3764092 A1 discloses a sensor based on an organic electrochemical transistor. The sensor comprises various components, including at least one source and drain electrode, a plurality of gate electrodes, and at least one channel connected to the source and drain electrodes. The sensor can be used to detect different analytes in a medium, if required, by specifying each gate electrode to detect a particular analyte.

A disadvantage of many of the OECTs already described is that the hysteresis in the current-voltage characteristic is often considered as a property to be minimized, so that the use of the OECT is still limited so far.

The object of the invention is to provide an electronic component with a volatile and non-volatile memory function for realizing complex electronic functions and a method for producing such an electronic component which enables to control the volatile and non-volatile memory function.

According to the invention, this object is solved by an electronic component in the form of an OECT and a method for producing it according to the independent claims. Advantageous embodiments of the invention are set forth in the dependent claims. In addition, possible uses of the device according to the invention are shown.

A first aspect of the invention relates to an electronic device in the form of an organic electrochemical transistor (OECT). This comprises at least a gate electrode, a source electrode, a drain electrode, a channel, and an electrolyte. All components of the OECT are arranged on a substrate, which is, for example, a glass plate, a silicon substrate, or a flexible substrate such as polyethylene terephthalate (PET).

In embodiments, the substrate serves not only as a carrier for the electronic component according to the invention, but also as a carrier for further components, conductive lines, etc.

The electrolyte is a solid electrolyte comprising a polymer and the channel has an organic semiconductor as the channel material. According to the invention, the electrolyte has a water content of at most 700 %.

All quantities listed in this publication are expressed in percent by mass (%w/w, weight percent), all percentages refer to the weight of the polymer content in the electrolyte (weight percent).

This will not be mentioned separately again in the following.

In embodiments, the electrolyte has a C1-C3-alcohol content of at most 700 %.

In further embodiments, the electrolyte has a halogen alkaline salt or alkaline earth salt or acetate salt content of at most 10 %.

The maximum water content or the maximum C1-C3-alcohol content of the electrolyte is 700 % in one embodiment, 200 % in a preferred embodiment, and 130 % in a most preferred embodiment.

A minimum water content or a minimum C1-C3-alcohol content of the electrolyte is 30 % in one embodiment, 70 % in a preferred embodiment, 100 % in another preferred embodiment, and 130 % in a most preferred embodiment. The term C1-C3-alcohol comprises methanol, ethanol and propanol.

The maximum halogen alkaline salt or alkaline earth salt or acetate salt content or the content of a combination of any of these salts is 10 % in one embodiment, 8 % in a preferred embodiment, 6 % in another preferred embodiment, and 4 % in a most preferred embodiment. Depending on the use of a particular salt or salt combination, the salt concentration will vary.

A minimum halogen alkaline salt or alkaline earth salt or acetate salt content is 0 % (zero) in one embodiment, 0.3 % in a preferred embodiment, 0.6 % in another preferred embodiment, and 4 % in a most preferred embodiment.

Suitable halogen alkaline salts or alkaline earth salts or acetate salts are for instance selected from KCl, NaCl, $CaCl_2$, zinc acetate or sodium acetate.

The control of the water content and C1-C3-alcohol content as well as the halogen alkaline salt or acetate salt or halogen alkaline earth salt content of the electrolyte, in particular the maximum content of these compounds, advantageously permits the provision of an electronic component with an adjustable bistable hysteresis in the switching behavior.

In an advantageous embodiment, the current-voltage characteristic of the OECT has a defined bistable hysteresis, the hysteresis being characterized by two separate branches through which the current-voltage characteristic passes depending on the output value of the gate source voltage. The branches have transition points (T1 and T2) with a voltage difference of at least 0.06 V and a slope (hard or soft hysteresis) of at most 150 mV/dec at room temperature. Room temperature is defined as 293,15 K. Bistability means that the OECT has a hysteresis with two operating points, which are defined by the same gate source voltage, but different drain currents, wherein the hysteresis and the operating points do not depend on the speed of the change of the gate source voltage or from time or from the range of the gate source voltage the OECT was driven through.

This hysteresis is a complex temporal dynamic that has a bistable character in addition to short-term effects.

The OECT can therefore be used as both a volatile and non-volatile memory.

Hysteresis characteristics such as slope, time constants, switching points, and bistability are determined by the water content, C1-C3-alcohol and amount of alkaline salt or alkaline earth salts or acetate salt in the electrolyte, but can also be influenced by device geometry and material composition.

Significant points on the hysteresis are, among others, the points H and L, which describe the value at which switching to the other stable hysteresis branch occurs, and the two points $M_H$ and $M_L$, which describe the two stable operating points on the hysteresis lying on the different branches of the hysteresis. There are two branches: a descending or upper branch, in which the drain current is high or decreases, and an ascending or lower branch, in which the drain current is low or increases. Ideally, the component is operated so that one branch is in the on state and the second branch is in the off state. The gate source voltage at point L must always be less than the gate source voltage at point $M_L$. Similarly, the gate source voltage at point H must always be greater than the gate source voltage at point $M_H$.

With this construction, the functional range of a Schmitt-Trigger can be realized (switch with two thresholds).

Other important properties of the hysteresis are the slope, in particular of the upper branch, and the hysteresis window, which is calculated as the voltage difference between the transition points.

The bistable hysteresis of the current-voltage characteristic is largely determined by the solid electrolyte. To use the hysteresis as a memory, a minimum hysteresis window is required.

For single gate OECTs, the hysteresis window is at least about 60 mV, and in a preferred embodiment, the hysteresis window is in the range of about 300 mV to 400 mV. For dual gate OECTs, the hysteresis window is in the range of 0.6 V to 0.8 V.

The slope can be used as a measure of the quality of the hysteresis. The steeper the slope, the less energy is lost during the switching process and the better you can distinguish between the two hysteresis arms.

The quality of the hysteresis can also be referred to as hard and soft, where a value of 150 mV/dec and higher (up to 300 mV/dec) is a soft hysteresis curve and a value of 57 mV/dec and lower is a hard hysteresis curve measured at room temperature.

In one embodiment, the descending hysteresis branch and the ascending hysteresis branch have a maximum value of 300 mV/dec and a minimum value of 57 mV/dec at room temperature.

In another preferred embodiment, the descending hysteresis branch and the ascending hysteresis branch have a slope of less than 100 mV/dec. The slopes of the two hysteresis branches may also be different. For example, the upper branch is approximately 60 mV/dec and the lower branch is approximately 100 mV/dec, i.e. the upper branch is steeper than the lower branch. Approximately means a variation of 10 %.

The electrolyte is a solid or gel in which at least one type of ion is mobile so that an electric current carried by these ions can flow. Solid electrolytes are electrically conductive, but unlike metals, they have little or no electronic conductivity.

The electrolyte preferably comprises a polymer and an ionic liquid, which together form a gel in which the three-dimensional network of the polymer is filled with the ionic liquid.

The polymer is preferably selected from polar organic or inorganic polymers capable of forming a conductive gel together with a polar liquid, in particular from the group of acrylamides, acrylates, phenones, PVDF (polyvinylidene fluoride) based polymers and perfluorosulfonic acid (PFSMA) polymers.

In embodiments, the polymer is composed of one or more materials of the following groups of materials:

- Nisopropylacrylamides (NIPAm),

- N,N'-methylenebisacrylamides (MBAm),

- 2-hydroxy-4'-(2-hydroxyethoxy)-2-methylpropiophenone (HHPAA),

In an embodiment, the polymer is composed of one or more materials from each of the above named groups of materials, wherein the one or more materials of the MBAm-group are present with a portion in the range of larger than zero (> 0) to 15 %, for instance 2.7 %, and the one or more materials of the HHPAA-group are present with a portion in the range 2.7 % to 50 %, for instance 27 %, wherein all portions are given in weight-percents and in relation to the one or more materials of the NIPAm-group (i.e. the portion of the one or more materials of the NIPAm-group corresponds to 100 %).

The following groups of substances are further exemplary:

- Polyethylene glycol diacrylate (PEGDA)

- 2,2-dimethoxy-2-phenylacetophenone (DMPA)

- Poly(vinylidene fluoride-co-hexafluoropropylene) (PVDF-HFP)

- Polystyrene-b-poly(methyl methacrylate) (PS-b-PMMA)

- 2-[1-[difluoro[(trifluoroethenyl)oxy]methyl]-1,2,2,2-tetrafluoroethoxy]-1,1,2,2-tetrafluoroethanesulfonic acid or Nafion,

- tetrafluoroethylene-perfluoro(3-oxa-4-pentenesulfonic acid) copolymer, or aquivion.

The electrolyte contains an ionic liquid in addition to the polymer.

Ionic liquids are selected from a variety of substance classes. They are liquid salts consisting of cations and anions. The melting temperature is below 373.15 K, preferably below 303.15 K. Typical cations are selected from imidazolium, pyrrolidinium, pyridinium, ammonium and. Typical anions are selected from inorganic and organic anions such as halide, tetrafluoroborate, hexafluorophosphate, trifluoracetate, triflate, tosylate, alkyl sulfates, fluorosulfonylamides and fluorossulfonylimides.

In embodiments, but not limited thereto, the following ionic liquids may be used:

- 1-ethyl-3-methylimidazolium ethyl sulfate (EMIM EtSO4).

- 1-ethyl-3-methylimidazolium bis(trifluoromethylsulfonyl)amide (EMIM TFSI)

- 1-ethylimidazolium bis(trifluoromethylsulfonyl)imide (EIM TFSI)

- 1-Butyl-3-methylimidazolium bis(trifluoromethylsulfonyl)imide

- 1-propyl-3-methylimidazolium bis(trifluoromethylsulfonyl)imide

- 1-Hexyl-3-methylimidazolium bis(trifluoromethylsulfonyl)imide

- 1-Hexyl-3-methylimidazolium hexafluorophosphate

- 1,3-Dihydroxy-2-methylimidazolium bis(trifluoromethylsulfonyl)imide

- 1,3-Diethoxyimidazolium bis(trifluoromethylsulfonyl)imide

- 1-Butyl-3-methylimidazolium tetrafluoroborate

- Ethyl-dimethyl-propylammonium bis(trifluoromethylsulfonyl)imide

- 1-butyl-1-methylpyrrolidinium bis(trifluoromethylsulfonyl)imide

and other ionic liquids based on imidazolium cations and various counterions (anions). The counterions may be organic anions or inorganic anions.

In one embodiment, additives are additionally, but not necessarily and not limited to, admixed.

Additives are substances or materials that are added to another material or product to achieve certain properties or effects. Here, in particular, the hysteresis is advantageously adapted. Examples include:

- Ethylene glycol,

- Deionized water

All polar solvents with a polarity > 0.30 groups with a melting point > 273.15 K and a boiling point > 343.15 K can also be used as additives. In addition, any water-soluble salts with a solubility product pKL < 25 (concentration from 0 % to 10 % of the polymer weight) can be considered. Exemplary ions are:

- Anions: Cl-, SO4-, NO3-, PO4-, Br-, F-, I-, O2-, acetate, etc.

- Cations: Mg2+, Ca2+, K+, Na+, Li+, Cs+, Be2+, Fe2+/3+, Cu2+/+, Ni+, Al3+, etc.

The electrolyte is called solid electrolyte even if it has viscous properties.

The thickness or depth of the gel on the substrate is 1 $\mu$m to 300 $\mu$m.

In one embodiment, the electrolyte during printing has a viscosity in the range of 8 mNs/nf to 12 mNs/m$^2$.

In another embodiment the electrolyte during printing has a viscosity in the range of 2 mNs/m$^2$ to 20 to mNs/m$^2$.

In a further embodiment the electrolyte during printing has a viscosity in the range of 20 mNs/nf to 500 mNs/m$^2$.

The gate electrode(s) is (are) used to control the charge transport in the organic semiconductor material of the channel, thereby controlling the current flow between the source and drain. By applying a voltage across the gate, ions from the electrolyte can be introduced into or removed from the organic semiconductor of the channel material, thereby changing the electrical conductivity of the channel material. By adjusting the voltage across the gate, the transistor can be controlled in its various operating states, such as on and off. For this purpose, the gate electrode(s) is (are) at least partially covered by the electrolyte, which also covers the channel and at least partially the source and the drain electrodes. In some embodiments, the whole gate electrode(s) is (are) covered by the electrolyte.

The gate electrode(s) is (are) preferably made of a material with good electrical conductivity. "good" means having a better (higher) conductivity than $37 \times 10^7$ S/m. Furthermore, the material of the gate electrode(s) should be chemical stable. Examples of electrode materials are gold (Au), platinum (Pt), silver (Ag), platinum-iridium (Ptlr). The electrodes can also be modified, e.g. Ag/AgCl electrodes. This can be achieved by HCl treatment or the direct use of Ag/AgCl inks.

However, other conductive materials can also be used, especially if they can positively change the characteristics of the OECT. In this case, materials with low electrical conductivity ($<37 \times 10^7$ S/m) can also be used, such as carbon in its various modifications like graphite or graphene. Furthermore, not only the electrical conductivity is important, but also the transition impedance (transition resistance) between the material of the gate electrode(s) and the material of the electrolyte. In order to reduce the transition impedance, the gate electrode(s) may also comprise or may be at least partially covered by a further material, for instance an organic semiconductor material like PEDOT:PSS, arranged towards the electrolyte. Ag/AgCl would also be an alternative here.

That region of the gate electrode(s) which is covered by the electrolyte or by the organic semiconductor and the electrolyte, is further called the active region of the gate electrode(s), and the base area of the active region is further called the active base area.

Each gate electrode is a solid figure (or body) formed from a base area and has a depth that may be constant across the area. In some embodiments, the depth can also vary, so there is a variety of depths. The base area can have any shape, e.g., square, rectangle, parallelogram, trapezoid, rhombus, triangle, circle, ellipse, hexagon, pentagon, quadrilateral, pentagon, hexagon, heptagon, octagon, nonagon, decagon, circular arc, semicircle, ring, or even combinations of the above shapes. Taking the depth into account, the corresponding base areas become solid figures.

In a preferred embodiment, the gate electrode is a cuboid having a width $w_{gate}$ along a first direction (X-axis), a length $l_{gate}$ along a second direction (Y-axis), and a depth $d_{gate}$ along a third direction (Z-axis).

In embodiments, the length $l_{gate}$ is in the range of 1 $\mu$m to 1 mm, the width $w_{gate}$ is in the range of 1 $\mu$m to 100 mm, and the depth $d_{gate}$ is in the range of 10 nm to 1 $\mu$m when considering only electrode material and in the range of 10 nm to 1 $\mu$m when considering an additional layer of, e.g., PEDOT:PSS.

In a preferred embodiment, the length $l_{gate}$ is in the range of 10 $\mu$m to 300 $\mu$m, the width $w_{gate}$ is in the range of 20 $\mu$m to 300 $\mu$m, and the depth $d_{gate}$ is in the range of 10 nm to 300 nm when considering only electrode material and in the range of 10 nm to 1 $\mu$m when considering an additional layer of, e.g., PEDOT:PSS.

The first, second, and third directions form a Cartesian coordinate system. The first direction connects the gate electrode in a straight line to the channel of the electronic device. The second direction runs along a straight line connecting the source and drain electrodes of the electronic device in the same plane as the first direction. The third direction is perpendicular to the plane in which the first and second directions extend.

In one embodiment, the transistor has only one gate. In another embodiment, the transistor has at least two gate electrodes. The dimensions of the gate electrodes, in addition to the materials used, significantly determine the characteristics of the transistor.

The size/area of the gate electrodes can, among other things, adjust the voltage window of the device.

The electrical capacitance of the gate electrode(s) has a decisive influence on the functionality. It is primarily determined by the electrode base area. If a further material, e.g., an organic semiconductor material, is arranged between the metal material of the gate electrode and the electrolyte, the electrical capacitance of the gate electrode is also determined by the thickness of the organic semiconductor material layer. The capacitance increases with increasing layer thickness of the organic semiconductor material.

In a preferred embodiment, the gate electrodes each have a base area about 10 times larger than that of the channel. "About" here means that areas with a deviation of 10 % in both positive and negative directions are included.

The distance between the gate electrode(s) and the channel is in the range of approximately 1 $\mu$m to 400 $\mu$m. "Approximate" here means that distances with a deviation of 10 % in both positive and negative directions are included. The distance is significant for the switching speed of the OECT.

In one embodiment, the distance is 400 μm, in a preferred embodiment, the distance is 50 μm, and in a most preferred embodiment, the distance is 10 μm.

In multi-gate OECTs, i.e., in OECTs with more than one gate electrode, all gate electrodes are independent.

If, for instance, the OECT comprises two gate electrodes, the ratio of the electrode areas, which are covered with the electrolyte material or with the organic semiconductor material and the electrolyte material, of the two gate electrodes, i.e. the ratio of the two active base areas, is chosen to be from 1:1 to 1:10, preferably from 1:1 to 1:5, and in an even more preferred embodiment from 1:1 to 1:2.

In another embodiment, the two (or more) gate electrodes are located at the same distance from the channel, wherein in one embodiment at least two gate electrodes lie on opposite side of the channel.

The source electrode serves as the entry point for current flow into the transistor. It is connected to the current source and delivers the current to the organic semiconductor of the channel. The source electrode allows the injection of charge carriers (electrons or holes) into the organic semiconductor.

The function of the drain electrode is to drain the current from the OECT and provide electrical contact to the semiconductor. Together with the gate(s), channel and source electrodes, the drain electrode forms the basic structural model of an OECT. By controlling the gate voltage, the current flow between the source and drain in the transistor can be regulated.

The source and drain electrodes can have different or the same structure. They can also have the same structure as the gate electrode. All combinations are possible, i.e., there are $2^{(x+2)}$ combination possibilities in an x-gate OECT system with regard to the design and the material properties used.

The source electrode makes electrical contact with the organic semiconductor material of the channel. This allows current to flow between the source electrode and the channel.

The drain electrode makes electrical contact with the organic semiconductor of the channel. This allows current to flow between the channel and the drain electrode.

In a preferred embodiment, the source and drain electrodes have the same material properties and body dimensions. In this regard, the source and drain electrodes, like the gate electrode, should have good electrical properties ("good" was defined above). The source and drain electrodes may have the same material as the gate electrode or a different conductive material. The same materials as for the gate electrode can be used.

In a preferred embodiment, the electrodes are L-shaped with respect to their footprint. The electrodes (x-gate, drain, source) have a depth (z-axis) that can be different or the same.

By applying a voltage to the gate electrode, the conductivity of the channel is influenced. This allows modulation of the carrier flow and thus control of the current flowing between the source and drain electrodes. The channel acts as the switching component of the OECT and allows the current flow to be enhanced or suppressed.

The channel allows the injection of carriers from the source electrode into the channel and the extraction of carriers to the drain electrode. This carrier flow is regulated by controlling the gate voltage. Depending on the type of OECT, the channel can transport either electrons or holes.

The channel in an OECT is responsible for carrier transport and controlling the current flow between the source and drain electrodes. By adjusting the gate voltage, the channel can be switched to different operating states, allowing the transistor to perform its function as an amplifier, switch, or sensor.

The channel can have different shapes of its base area, e.g., square, rectangle, parallelogram, trapezoid, rhombus (diamond), triangle, circle, ellipse, hexagon, pentagon, quadrilateral, pentagon, hexagon, heptagon, octagon, nonagon, decagon, circular arc, semicircle, ring, or combinations of these shapes. When a depth is taken into account, the base area becomes a solid figure.

In a preferred embodiment, the channel is cuboidal and has a length $l_{channel}$ (measured along the second direction, i.e., the y-axis), a width $w_{channel}$ (measured along the first direction, i.e. the x-axis), and a depth $d_{channel}$ (measured along the third direction, i.e. the z-axis), the orientation being according to the Cartesian coordinate system described above.

Advantageously, the channel has the following dimensions, without being limited thereto.

In a first preferred embodiment, the channel has dimensions in the following ranges:

$$L_{channel} = 1 \text{ μm to } 1 \text{ mm}, \quad W_{channel} = 1 \text{ μm to } 1 \text{ mm}, \quad d_{channel} = 10 \text{ nm to } 1 \text{ μm}.$$

In a second preferred embodiment, the channel has dimensions in the following ranges:

$$L_{channel} = 10 \text{ μm to } 200 \text{ μm}, \quad W_{channel} = 10 \text{ μm to } 200 \text{ μm}, \quad d_{channel} = 50 \text{ nm to } 250 \text{ nm}.$$

The channel comprises at least one organic semiconductor material.

The organic semiconductor material is preferably a heterocyclic π-conjugated oligomer or polymer. In this class of materials, the electrons involved in the π bonds are not localized at one atom but are delocalized in the region of the entire conjugated π electron system, forming molecular orbitals. In organic semiconductors, charge transport is described by hopping of carriers between the π-electron systems.

The organic semiconductor material must be conductive (through a conjugated electron system) and hydrophilic to allow ions to penetrate (e.g., through ethylene glycol side chains, but other side chains are possible).

The organic semiconductor material is preferably selected from thiophene (including benzodithiophene), benzodifurandione, benzimidazobenzophenanthroline, pyrazines, thiazole, dithienyl, diazaisoindigo, lactam, naphthalene and diketopyrrolopyrrole based materials.

Embodiments of the organic semiconductor material may have the following material composition; these cores may be combined as desired as copolymers:

- Thiophene-based semiconductors with ethylene glycole side groups.

- Poly(3,4-ethylenedioxythiophene) polystyrene sulfonate (PEDOT:PSS).

- Poly(3,4-ethylenedioxythiophene) with other counterions, for example tosylates or poly[(4-styrenesulfonyl) (trifluoromethanesulfonyl)

- Thieno[3,2-b]thiophene (TT) Cores

- Thiophene cores can also be separated from each other by double bonds, for example dithienylethene cores.

- Dithiophenes, for example 4H-cyclopenta[1,2-b:5,4-b']dithiophenes, benzo[1,2-b:4,5b']dithiophene-4,8-diones, bithiophene imides

- Benzodifurandione-based cores

- dialkoxybithiazole cores

- 7,7'-diazaisoindigo-based cores

- Lactam/naphthalene-based cores with and without keto groups

- Diketopyrrolopyrroles (DPP) Cores

- Poly(benzimidazobenzophenanthrolines) (BBL)

- Pyrazine cores

- Naphthalene diimide (NDI) Cores

Up to three possible cores with arbitrary side chains can be realized. The following side chains are possible, among others:

- Ethylene glycole side chains can have a length of 2 to 7 units. Cores with and without ethylene glycol side chains can be combined.

- Ethylene glycol side chains can be directly linked to oxygen at the core or have aliphatic "spacers", e.g. methyl, ethyl, propyl, and butyl groups.

- Alkyl side chains in different lengths from C2 up to C32 are possible.

- Branched alkyl side chains in various lengths

- Ether groups and ester groups of various chain lengths

- Fluorine and other halogens

- Charged side chains, for example.

In addition, the organic semiconductor material can be provided with additives. The following list shows possible examples of additives:

- Dimethyl sulfoxides (DMSO)

- Ehtylene glycol

- (3-glycidyloxypropyl)trimethoxysilanes (GOPS)

- Ionic liquids

- Sorbitol

- glycerol

- TCNQ, F4TCNQ and other organic semiconductor dopants

- Poly(ethylene glycols) of various chain lengths. Oligomers also possible.

- Zonyl fluorosurfactant (Zonyl)

- Polyethyleneimine (PEI)

- Other basic amines to dedote PEDOT:PSS

The solid electrolyte sufficiently covers the gate electrode(s) - more than two gate electrodes are possible - the channel, the drain electrode, and the source electrode.

The channel can be completely covered by the electrolyte, i.e. 100 % of the channel is covered, but it is also possible that only a part of the channel is covered. Also, the gate electrode(s) may be only partially covered by the electrolyte but must be in electrical contact with the organic semiconductor material of the channel via the electrolyte.

"Sufficiently" means that the functionality of the transistor must be completely fulfilled, i.e. the charge carriers (ions) can migrate into the channel accordingly.

The electronic component according to the invention can be manufactured using processes known to those skilled in the art. As an example, a possible process is described herein which includes the following steps:

- Providing a substrate

- Fabricating the gate, source and drain electrodes on the substrate, for example by printing gold pastes and then sintering. Other possibilities include sputtering, evaporation, electroplating, and others, possibly followed by a patterning step. Of course, the process used depends on the materials used for the electrodes.

- Application of the organic semiconductor material to the channel region and, if necessary, to the gate electrode and/or to the source and drain electrodes, e.g. by spin coating or evaporation, possibly followed by a patterning step.

- Application of the solid-state electrolyte over the channel region and at least partially over the electrodes, for example by means of printing processes.

In addition, the process may include other steps, such as the application of a protective coating. To protect the organic material and the electrodes from external influences, a protective polymer layer or a thin metal layer can be applied. Of course, electrical connections to the outside must be made in order to provide a current at the source and a voltage at the gate, and to dissipate a current at the drain, so that the fabricated OECT can be operated. Connection techniques are known to those skilled in the art.

A second aspect of the invention relates to the use of an electronic device according to the invention as a Schmitt-Trigger or a Muller-C-element or a flip-flop or a 1-bit memory. Each of these uses is described in more detail below.

Advantageously, the use of the electronic component according to the invention enables a high efficiency of the realized circuits. Even complex circuits require less space and less current, thus enabling a higher integration density and a longer operating time in battery mode than conventional realizations. Another advantage is the reduced susceptibility to external interference.

The Schmitt-Trigger is a fundamental component for various circuits. These include:

1. bi- and multistable multivibrators

   a. Flip-flop or latch (memory),
   b. Muller-C-elements (latch + NAND) or parity checkers (XOR + D flip-flop),

2. monostable oscillators (artificial neurons)

3. Astable circuits

   a. relaxation oscillators,

   b. event triggers or

   c. random number generators.

A Schmitt-Trigger is a circuit that converts an input voltage to one of two defined output voltages and has hysteresis. A Schmitt-Trigger does not respond to a change in the input voltage until it exceeds or falls below a certain threshold. When one of the thresholds is reached, the output of the Schmitt-Trigger switches to the other state and remains in that state until the input voltage reaches the other threshold and switches again. There are exactly two thresholds, one for the upper hysteresis branch and one for the lower hysteresis branch. The other threshold is used to switch the output. This means that the threshold L that causes switching from the lower to the upper hysteresis branch does not cause "switching back" when it is reached again, but a threshold H must first be exceeded.

"Switching back" means that the output level changes to the previous state.

A Schmitt-Trigger is an electronic circuit that converts an input voltage $V_{in}$ to an output voltage $V_{out}$ with a certain threshold. When the input voltage exceeds the upper threshold voltage (VTH+), the output voltage goes to a high logic level (usually the supply voltage).

When the input voltage falls below the lower threshold voltage (VTH-), the output voltage goes to a low logic level (usually ground potential). The output voltage remains in its current state as long as the input voltage is between the switching thresholds.

A Schmitt-Trigger is often used as a signal shaping circuit to convert a noisy or interfering input voltage into a clean and stable digital output voltage. Schmitt-Triggers are used in many different applications, such as circuitry for switches, clock generation, triggers, oscillators, and many other types of circuitries.

One way to implement the Schmitt-Trigger with conventional components is to use an op amp with positive feedback so that the output voltage is used as part of the input control. The feedback loop is designed to have hysteresis, i.e. the switching thresholds for the transition from high to low level and vice versa are different.

Basically, a conventional Schmitt-Trigger consists of at least two transistors, an input resistor and a feedback resistor. However, the number of transistors depends on how the Schmitt-Trigger is implemented, whether bipolar transistors (BJTs) or field-effect transistors (FETs) are used, and whether additional protection circuitry or logic functions are required.

Typically, a Schmitt-Trigger of conventional design built with bipolar junction transistors (BJTs), consists of be a of 2 to 4 transistors and several resistors, depending on the design. Schmitt-Triggers can also be implemented using field effect transistors (FETs), although the complexity of the circuit may be less due to the higher input impedance of FETs. Depending on the technology and design, as few as 2 transistors may be sufficient if resistors can also be incorporated Ultimately, the number of transistors for a Schmitt-Trigger depends on the specific requirements of the circuit. However, there are usually several efficient circuit designs that meet most requirements and require only a few transistors.

Conventional C-MOS (Complementary Metal Oxide Semiconductor) circuits typically use 6 transistors and no resistors to realize Schmitt-Trigger integrated circuits. By utilizing the bistable hysteresis that the subject matter of the invention already possesses due to the novel solid electrolyte, the same functionality can be achieved with only one component.

A Muller-C-element may also be referred to as a C-gate, hysteresis flip-flop, coincident flip-flop, or two-hand safety circuit. In the following, the term Muller-C-element will be used. A Muller-C-element is a circuit used to generate a square wave signal based on a Schmitt-Trigger.

The Muller-C-element is commonly used in digital circuits to realize a handshaking module for asynchronous electronics. It is therefore of primary importance in this branch of electronics and is found in nearly all asynchronous systems.

The circuitry of the Muller-C-element can be either dynamic, in which an internal node such as a capacitor stores the previous state, or static in which a latch is used to this effect. The number of transistors in a CMOS implementation of Muller C-elements varies between 6-10 depending on the design.

More complex circuits, requiring higher accuracy and wider bandwidth, may contain several dozen transistors. In addition, the choice of technology (e.g., bipolar vs. CMOS) and manufacturing process can affect the number of transistors required for implementation. A typical number of transistors in conventional electronics is about 8-10 pieces. Overall, the number of transistors required for a hysteresis flip-flop is highly dependent on the specific circuit and there are many different designs.

The electronic component according to the invention has a pronounced hysteresis, which has not been considered for use in a Muller C-element.

Hysteresis in this context means that the response of a system to a change in input depends not only on the current input, but also on the previous state history of the system.

The electronic device has at least two input variables $x_1$, $x_2$, ... $x_{n+1}$ and one output variable y.

In the following, the electronic component with two inputs ($x_1$ and $x_2$), i.e. two gate-source voltages, will be described. The quantitative input variables of the system determine the operating point on the hysteresis. It is valid that the logic levels of $V_{GS1}$ and $V_{GS2}$ are to be designed in such a way that the following truth table can be realized, where $Z_{up}$ stands for a stable point on the rising branch and $Z_{down}$ for a stable point on the falling branch of a hysteresis curve.

Table 1: Muller-C-element truth table

| $X_1$ | $X_2$ | Y |
|---|---|---|
| 0 | 0 | $Z_{up}$ (0) |
| 0 | 1 | Last value |
| 1 | 0 | Last value |
| 1 | 1 | $Z_{down}$ (1) |

The voltage levels of $V_{GS1}$ and $V_{GS2}$ must be selected in such a way that a jump from one stable operating point of the hysteresis to the other stable operating point only occurs when $x_1$ = H and $x_2$ = H or $x_1$ = L and $x_2$ = L, respectively. For all other possible combinations, i.e. $x_1$ = H and $x_2$ = L, $x_1$ = L and $x_2$ = H, the last output value, i.e. the last operating point, should be maintained.

The voltage difference between the two points L and H must be at least 200 mV, ideally 500 mV, and less than 1 V.

The value of $V_{GS}$ for $M_H$ and $M_L$ is ideally in the middle between the voltage $V_{GS}$ at point H and the voltage $V_{GS}$ at point L, respectively for the voltage between H and L where the current Id at point H minus the current at point L is maximum.

The voltage ranges can vary depending on the shape of the hysteresis curve.

An RS or SR flip-flop corresponds (typically) to the following truth table, for which conventional field-effect transistors in C-MOS technology are used.

Table 2: Truth table flip-flop

| S | R | $Q_{next}$ | state |
|---|---|---|---|
| 0 | 0 | Q | hold |
| 0 | 1 | 0 | reset |
| 1 | 0 | 1 | set |
| 1 | 1 | X | Not allowed |

With the electronic component according to the invention, this functionality can be achieved by utilizing bistable hysteresis. The device has two inputs S and R to which a voltage can be applied.

The voltage $V_{GS1}$ is applied to input S and the voltage $V_{GS2}$ is applied to R. The voltage levels are adjusted in such a way that a stable operating point is assumed at the bistable hysteresis. A defined voltage level of $V_S$ at terminal S causes the operating point on the hysteresis curve to shift in the direction (upper hysteresis branch).

A defined voltage level of $V_R$ at terminal R causes the operating point on the hysteresis curve to shift in direction (lower hysteresis branch).

If Vs is applied to S and "no voltage" is applied to R or $V_R$ is applied to R and "no voltage" is applied to S, the operating point does not change (memory state).

"No voltage" means the voltage range between -1 V and 0.3 V.

Voltage levels for $V_R$ and/or Vs are in the range of -1.5 V to 1.5 V. Voltage level for $V_R$ can be equal to Vs and vice versa. Voltage levels can also be independent, i.e. $V_R$ is not equal to Vs.

The connections are interchangeable, it is also possible that the voltage Vs is applied to R and $V_R$ to S.

If Vs is applied to S and $V_R$ is applied to R, an undefined/indeterminate state prevails (table 2 S=1, R=1).

A memory chip is an electronic component consisting of an input x and an output y. The internal memory is used to store data.

The internal memory uses the bistability of the hysteresis already described.

In one embodiment, the voltage $V_{DS}$ is measured across the transistor. A low level (L) is detected when a current $I_d$ is greater than a defined minimum current $I_{dH-min}$ and less than a defined maximum current $I_{d-H-max}$. A high level (H) is detected when a current $I_d$ is less than a defined maximum current $I_{dL-max}$ and greater than a defined minimum current $I_{dL-min}$.

For the high level, the exemplary range is 0.41 V to 1.5 V.

For the low level, a range of 0.4 V to -1.5 V is given as an example.

Other voltage ranges are also possible. For example, in one embodiment, the voltage range for high level is 0.01 V to 1.5 V and for low level is -1.5 V to 0 V.

There are two memory states, H and L, representing logic 1 and logic 0. The voltage levels can be applied to one or more gate electrodes.

The logic 1 and logic 0 memory states are achieved by exceeding or falling below the voltage levels, respectively.

In a preferred embodiment, the upper voltage level is defined as $V_{GS-H}$ = 0.4 V to -1.2 V and the lower voltage level is defined as $V_{GS-L}$ = 0.41 V to 1.2 V.

The memory keeps the last state (storage): when the high level is exceeded, the output delivers a logic 1 state, until the voltage falls below the low level, resulting in a logic 0 at the output till the voltage again exceeds the high level.

A third aspect of the invention refers to a method for producing a OECT according to the invention.

The method for producing an electronic component comprises the following steps:

- forming at least one gate electrode,

- forming a source electrode,

- forming a drain electrode,

- forming a channel comprising an organic semiconductor as a channel material, and

- forming an electrolyte, being a solid electrolyte comprising a polymer.

The electrolyte has a maximum water content of 700 %, wherein the percentage refers to the weight of the polymer content in the electrolyte (weight percent).

It is possible to modify the hysteresis properties with the help of UV irradiation (UV stands for ultraviolet light.). For this purpose, the entire component is irradiated. By applying UV irradiation, the hysteresis can be influenced so that it is reduced to a minimum. This allows the hysteresis effect to be eliminated so that the OECT can be used like a conventional OECT without hysteresis. Thus, a circuitry comprising at least one OECT with hysteresis, i.e. a OECT according to the invention, and at least one OECT without hysteresis or with a very small hysteresis, i.e. a conventional OECT, may be formed simultaneously in one fabrication process, wherein only that at least one OECT, which has to be a conventional OECT, is additionally treated with UV light in order to change it from a OECT with a hysteresis into a conventional OECT.

It is also possible to adjust the hysteresis by UV exposure of the organic semiconductor, e.g. PEDOT:PSS, which forms the channel and which may be formed at least partially on the at least one gate electrode.

The primary effect of UV irradiation is a shift in the threshold voltage. This makes it possible to build simple inverters (because the transistor becomes an enhancement type transistor). The hysteresis disappears with the time of UV irradiation and disappears completely afterwards. The hysteresis disappears very quickly by irradiation, while the threshold voltage can be pushed further by longer irradiation.

The embodiments of the invention described in the foregoing description are examples given by way of illustration and the invention is nowise limited thereto. Any modification, variation and equivalent arrangement as well as combinations of embodiments or of some features of embodiments should be considered as being included within the scope of the invention as long as they are not mutually exclusive.

In embodiments, the exposure to UV light is performed after forming the whole OECT. In other embodiments, the exposure to UV light is performed directly after forming the electrolyte or directly after forming the organic semiconductor.

By using UV light, the hysteresis can be reduced to a minimum.

The irradiation dosage can be provided in one step or in several steps, the dose of each step can vary or always be chosen the same. In an embodiment, the irradiation is performed in at least two steps. In another embodiment, more than 100 steps may be used.

In embodiments, the additionally exposed UV light has a range of 100 nm to 455 nm. In each embodiment, the dose may vary from 100 mJ/cm$^2$ to 10000 mJ/cm$^2$.

In one embodiment, the electronic component, i.e. the OECT, is exposed to 365 nm UV light at a dose of 1500 mJ/cm$^2$ after fabrication.

In one embodiment, four exposure steps are used, each using 350 mJ/cm$^2$.

The hysteresis of the OECT can also be influenced by the salt content of the electrolyte. By adding salt, the OECT with hysteresis can also be used as a conventional OECT without hysteresis. The salt influences the hysteresis property so that it can be reduced to a minimum.

In one embodiment, the salt content of the electrolyte is equal or less than 10 % (weight percent).

In another embodiment, the salt content of the electrolyte is equal or less than 8 % (weight percent).

In a further embodiment, the salt content is at least 5 % (weight percent).

Salts like $CaCl_2$ can be added, but ionic liquids are not suitable.

In the following passages, an exemplary method for manufacturing an OECT according to the present invention will be described. All fabrication steps and experiments were performed under standard cleanroom conditions.

The solid electrolyte precursor solution was developed for inkjet printing which necessitated the optimization of the viscosity of the ink (10 mNs/m$^2$). It contains deionized water (1.5 mL), N-isopropylacrylamide (monomer, 750.0 mg), N, N'-methylenebisacrylamide (crosslinker, 20. 0 mg), 2-hydroxy-40-(2-hydroxyethoxy)-2-methylpropiophenone (initiator, 200.0 mg), and 1-ethyl-3-methylimidazolium ethyl sulfate (ionic liquid, 1.5 mL). Metallic electrodes are deposited by thermal deposition through a shadow mask (Cr (3 nm) and Au (50 nm)).

PEDOT:PSS (Clevios PH1000) with 5 % v/v ethylene glycol was spin-coated (3000 rpm for 60 s) to obtain an approximately 100 nm thick layer. The PEDOT:PSS can be structured by photolithography. Alternative, the ink can be also printed, e.g. using an inkjet printer.

The solid electrolyte was applied using an inkjet printing process.

In the following, the invention will be explained in more detail by means of exemplary embodiments and figures. The examples are intended to describe the invention without limiting it. The dimensions of the individual elements and their relationship to one another are not shown to scale, but only schematically. Identical reference signs indicate corresponding components of the same type.

Fig.1 shows a top view of an OECT according to the invention with one gate terminal.

Fig.2 shows the structure of the OECT of Fig. 1 in a cross section along the line A-A.

Fig.3 shows a side view of the OECT of Fig.1.

Fig.4 shows schematically the hysteresis curve of the OECT according to the invention with significant values.

Fig.5 shows a schematic top view of an OECT according to the invention with two gate terminals. This figure is used to show, among other things, the voltages.

Fig.6 shows different representations of a Muller-C-element realized with conventional electronic components.

Fig.7 shows the structure of a Schmitt-Trigger in CMOS technology.

Fig.8 shows Muller-C-elements with more than two inputs, realized by conventional electronic components.

Fig.9 shows a transfer characteristic of an exemplary embodiment with and without salt (CaCb).

Fig.10 shows an output curve of unipolar inverter (passive load) without hysteresis.

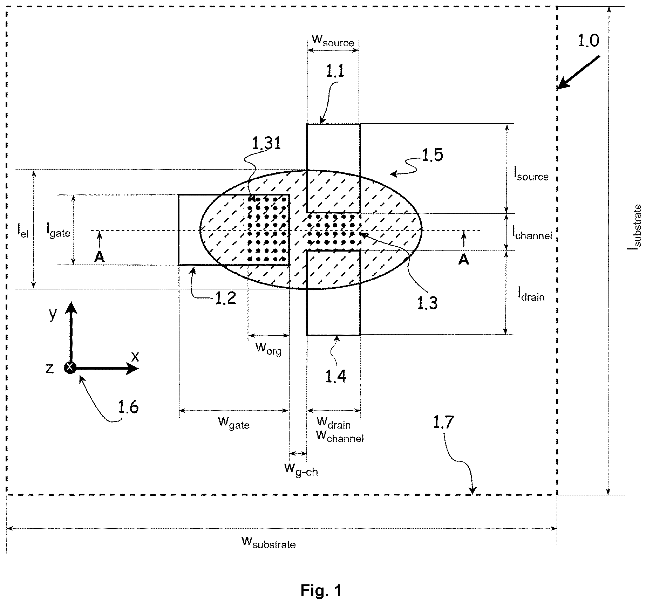

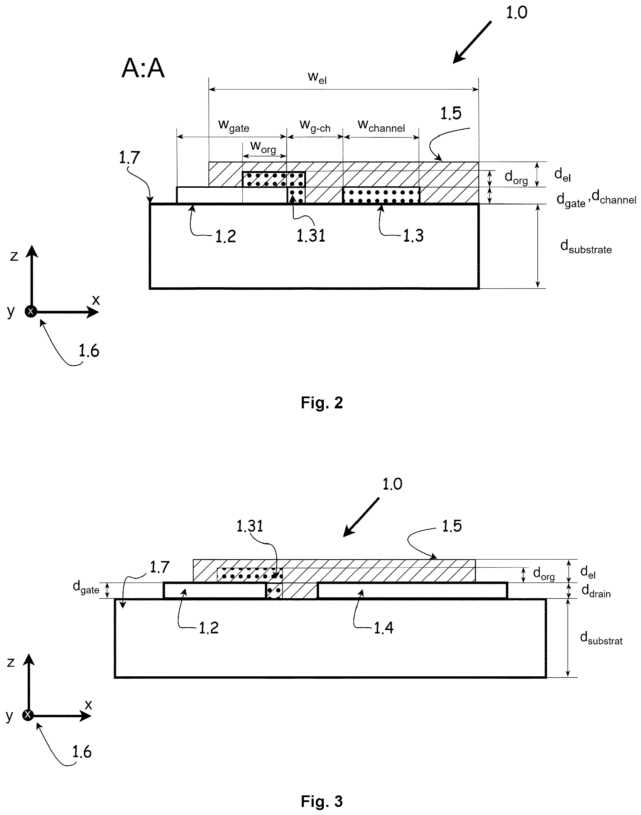

With respect to **Figs. 1 to 3**, a first exemplary embodiment 1.0 of an OECT according to the invention will be described. Figure 1 shows a top view on OECT 1.0, whereas Fig. 2 shows a cross-section through the OECT 1.0 along line A-A in Fig. 1, and Fig. 3 shows a side view of the OECT 1.0. The shown organic electrochemical transistor (OECT) 1.0 is formed in a single gate configuration.

In this embodiment, the outlined OECT 1.0 has a source electrode 1.1, a drain electrode 1.4, a gate electrode 1.2 and a channel 1.3. All electrodes, i.e. the source electrode 1.1, the gate electrode 1.2 and the drain electrode 1.4 as well as the channel 1.3 are connected to an electrolyte 1.5. The shown elliptical shape of the electrolyte 1.5 shows a possible design variant. The gate electrode 1.2 is designed as a cuboid with a width $w_{gate}$ along a first direction (x-axis), a length $l_{gate}$ along a second direction (y-axis) and a depth $d_{gate}$ along a third direction (z-axis), wherein the depth is shown in Fig. 2 and Fig. 3. The Cartesian coordinate system 1.6 again clarifies the reference directions.

The channel 1.3 has a width $w_{channel}$ = 100 $\mu$m and a length $l_{channel}$ = 50 $\mu$m and consists of an organic semiconductor material PEDOT:PSS. In this exemplary embodiment, the width $w_{channel}$ of channel 1.3 is equal to a width $w_{source}$ of the source electrode 1.1 and a width $w_{drain}$ of the drain electrode 1.4. The length $l_{channel}$ of the channel 1.3 is equal to the length $l_{gate}$ of the gate electrode 1.2.

The gate electrode 1.2 is made of gold and has the dimensions $l_{gate}$ = 150 $\mu$m, $w_{gate}$ = 300 $\mu$m and $d_{gate}$ = 30 nm. A part of the surface of the gate electrode 1.2, the part facing the channel 1.3, is coated with an organic semiconductor material 1.31 which is identical to the organic semiconductor material of the channel 1.3. This part of the gate electrode 1.2, which is also covered by the electrolyte 1.5 and is called the active region of the gate electrode, has a width $w_{org}$ along the first direction and extends over the entire depth of the gate electrode 1.2 and over the entire length of the gate electrode 1.2. In other embodiments, the coated portion of the gate electrode may extend only over at least the length of the channel. In further embodiments, the organic semiconductor material with which the gate electrode is partially coated may also be different from the material of the channel. In further embodiments, the gate electrode may not be coated with an organic semiconductor material at all.

The gate electrode 1.2 is located at a distance $w_{g-ch}$ from the channel 1.3, where the distance $w_{g-ch}$ is measured along the first direction. The distance $w_{g-ch}$ is, for example, 30 $\mu$m.

The source electrode 1.1 is also made of gold and has the dimensions $l_{Source}$= 300 $\mu$m, $w_{source}$ = 100 $\mu$m and $d_{source}$ = 30 nm.

The drain electrode 1.4 is also made of gold and has the dimensions brain= 300 $\mu$m, $w_{drain}$= 100 $\mu$m and $d_{drain}$ = 30 nm.

The electrolyte 1.5 is a solid electrolyte and consists of DI water, N-isopropylacrylamide, N, N'-methylenebisacrylamide, m 2-hydroxy-40-(2-hydroxyethoxy)-2-methylpropiophenone, and 1-ethyl-3-methylimidazolium ethyl sulfate. The water could be substituted by ethanol or methanol. It has a maximum water content (or ethanol or methanol) of 700 % and a minimum water content of 30 %. The electrolyte 1.5 is arranged over the channel 1.3 and the region between the channel 1.3 and the gate electrode 1.2 and at least partially over the gate electrode 1.2, the source electrode 1.1 and the drain electrode 1.4. In the example shown, the electrolyte 1.5 has an elliptical shape in plain view with a width $w_{el}$ of 300 $\mu$m measured along the first direction (x-axis) and a length $l_{el}$ of 100 $\mu$m measured along the second direction (y-axis).

All components of the OECT 1.0 are arranged on a substrate 1.7, which is made of glass or polyimide and can serve also as a carrier for components other than the OECT 1.0. The substrate 1.7 can be a rigid flat surface or it can be flexible as long as the adhesion of the components of the OECT 1.0 to the substrate 1.7 and the function of the OECT 1.0 are guaranteed.

The substrate 1.7 has a length $l_{substrate}$, a width $w_{substrate}$, and a depth $d_{substrate}$, wherein the length $l_{substrate}$ is measured along the first direction (x-axis), the width $w_{substrate}$ is measured along the second direction (y-axis) and the depth $d_{substrate}$ is measured along the third direction (z-axis).

Exemplary dimensions are: $l_{substrate}$ = 25,4 mm, $w_{substrate}$ = 25,4 mm.

**Figure 2** shows the section A:A of Fig. 1. On the substrate 1.7, the gate electrode 1.2 and the channel 1.3, which are arranged at a distance $w_{g-ch}$ from each other, are covered with the electrolyte 1.5 in such a way that they are ion-conductively connected. The electrolyte 1.5 is designed to be located in the spaces between the gate electrode 1.2 and the channel 1.3. In the embodiment shown, all surfaces of the channel are connected to the electrolyte 1.5 except for the end surfaces that connect the channel to the drain or source electrode planar. In this embodiment, only that part of the gate electrode 1.2, which is coated with the organic semiconductor material 1,31, contributes to the electrical performance of the OECT 1.0 due to the high transition impedance of the gate electrode 1.2 where it is directly connected to the electrolyte 1.5. The part of the gate electrode 1.2 coated with the organic semiconductor material 1.31 extends along the first direction with the width $w_{org}$.

The gate electrode 1.2 has a depth $d_{gate}$ equal to the depth $d_{channel}$ of the material of channel 1.3. The depths of the source and drain electrodes, $d_{source}$ and $d_{drain}$, which are not shown in Fig. 2, are also equal to $d_{gate}$. The electrolyte 1.5 has a thickness or depth $d_{el}$ of 30 $\mu$m above the gate electrode 1.2 and the channel 1.3. In embodiments, the thickness of the electrolyte may also vary over its extent. For example, it can be seen in Fig. 2 that the electrolyte 1.5 is thicker than $d_{el}$ in regions of the cross-section where it does not rest on the gate electrode 1.2 or the channel 1.3. In other embodiments, this may not be the case, or the thickness of the electrolyte may decrease or increase towards its edges.

The substrate 1.7 has the depth $d_{substrate}$ of 75 $\mu$m.

**Figure 3** shows the OECT from Figure 1 rotated 90 degrees clockwise around the X-axis to give a side view. In particular, the different layer thicknesses of the different OECT components can be seen, i.e. the depth $d_{gate}$ of the gate electrode 1.2, the depth $d_{drain}$ of the drain electrode 1.4 and the depth $d_{el}$ of the electrolyte 1.5 as well as the depth $d_{substrate}$

of the substrate 1.7. In this embodiment, the gate electrode 1.2 and the drain electrode 1.4 have the same layer thickness.

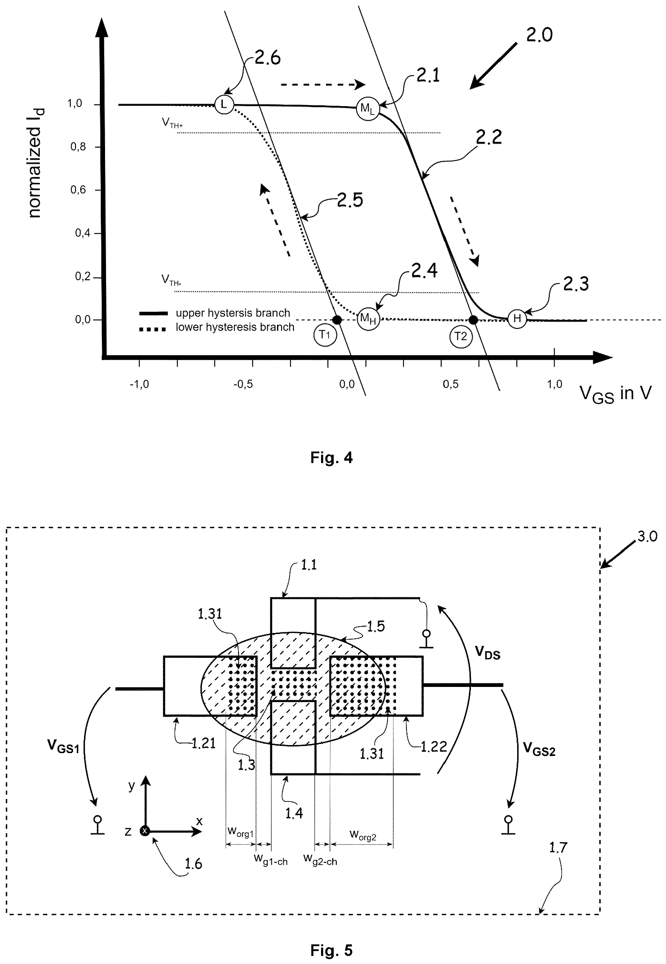

**Figure 4** shows a hysteresis curve 2.0 of an OECT according to the present invention with a rising edge 2.5 of a lower hysteresis branch and a falling edge 2.2 of an upper hysteresis branch. The normalized current $I_d$, i.e. the drain current, is plotted on the ordinate and the gate-source voltage $V_{GS}$ on the abscissa.

The coordinates H 2.3 and L 2.6 (and the respective gate source voltage values) mark the switching points where one hysteresis branch changes to the other. The points $M_H$ 2.4 and $M_L$ 2.1 represent two stable operating points within the hysteresis for one and the same operating gate source voltage. That is, the drain current $I_d$ for the operating gate source voltage depends on which branch of the hysteresis the OECT is present at this point of time. Or in other words: the drain current depends on which transition point, H or L, the gate source voltage reached at last. It is desired that the drain current differs for the two operating points $M_H$ and $M_L$ for at least the factor 10, i.e. $I_d (M_L) \geq 10 \times I_d (M_H)$. In some embodiments, the factor for the drain currents for the two operating points is around 10000.

A characteristic property of the hysteresis is the slope, which can be different for the upper hysteresis branch 2.2 (solid line) and the lower hysteresis branch 2.5 (dashed line). This property determines whether the hysteresis curve is hard or soft. It is desired that the slope, in particular of the upper hysteresis branch, is high enough, to reach the desired difference in the drain current, but not too high in order to limit the drain current for operating point $M_L$ and thus the power consumption of the OECT. Therefore, the slope of the upper branch is in the range of 57 mV/dec to 150 mV/dec, in particular in the range of 60 mV/dec to 100 mV/dec. On the other hand, the slope of the upper branch is only one parameter for the power consumption, another one is the gate source voltage of the operating points $M_H$ and $M_L$. If the slope is small, i.e. the branch is steep, the difference between the gate source voltage of the transition point H and the operating gate source voltage should be relatively small, wherein the difference between the named two gate source voltage values may be higher for a high slope.

Points T1 and T2 represent characteristic values on the hysteresis curve. The voltage difference between the points describes the hysteresis window. A hysteresis window refers to the range or interval between characteristic points on a hysteresis curve, T1 and T2. These points mark the threshold above which a physical system, such as a material or electronic component, shows a change in its behavior or property.

**Figure 5** shows a second embodiment 3.0 of the OECT according to the invention. The OECT 3.0 is very similar to the first embodiment 1.0 and same components are tagged with the same reference signs and not described again. However, the OECT 3.0 now comprises two gate electrodes, a first gate electrode 1.21 and a second gate electrode 1.22, which have in principle the same design as the gate electrode 1.2 of the OECT 1.0., The two gate electrodes 1.21 and 1.22 are arranged mirrored on the imaginary center line of the channel 1.3 with respect to the width of the channel. The centerline of channel 1.3 is parallel to the y-axis. The rest of the structure is identical to the OECT 1.0 shown in Fig. 1. However, the two gate electrodes 1.21 and 1.22 differ in the width of the part covered by the organic semiconductor material 1.31 of channel 1.3. Thus, the width $w_{org1}$ of the first gate electrode 1.21 is smaller than the width $w_{org2}$ of the second gate electrode 1.22, with the ratio $w_{org1}:w_{org2} = 1:3$ in the example shown. That is, the active areas of the two gate electrodes 1.21 and 1.22 differ from each other and have a ratio of 1:3 in the shown example. In the illustrated example, the two gate electrodes 1.21 and 1.22 are located on opposite sides of the channel 1.3, the distance $w_{g1-ch}$ of the first gate electrode 1.21 from the channel 1.3 being equal to the distance $w_{g2-ch}$ of the second gate electrode 1.22 from the channel 1.3. The widths $w_{org1}$ and $w_{org2}$ and the distances $w_{g1-ch}$ and $w_{g2-ch}$ or the ratios of these values to each other can be used to adjust the influence of the respective gate electrode on the conductivity of the channel 1.3. Although not shown here, both gate electrodes can also be placed on one side of the channel 1.3, i.e. side by side, as long as both can influence the channel 1.3. It is also possible to provide more than two gate electrodes, which can be placed on one or both sides of the channel 1.3.

The graph also shows significant voltages on the OECT. The consumer counting arrow system (VZS) is used.

Voltage $V_{GS1}$ represents a potential difference between gate 1 (the gate electrode 1.21) and the source electrode 1.1, where a positive voltage indicates an orientation from the gate electrode 1.21 to the source electrode 1.1. The source electrode 1.1 is connected to ground.

Voltage $V_{GS2}$ represents a potential difference between gate 2 (the gate electrode 1.22) and the source electrode 1.1, where a positive voltage indicates an orientation from the gate electrode 1.22 to the source electrode 1.1.

Voltage $V_{DS}$ represents a potential difference between the drain electrode 1.4 and the source electrode 1.1, where a positive voltage indicates an orientation from the drain electrode 1.4 to the source electrode 1.1.

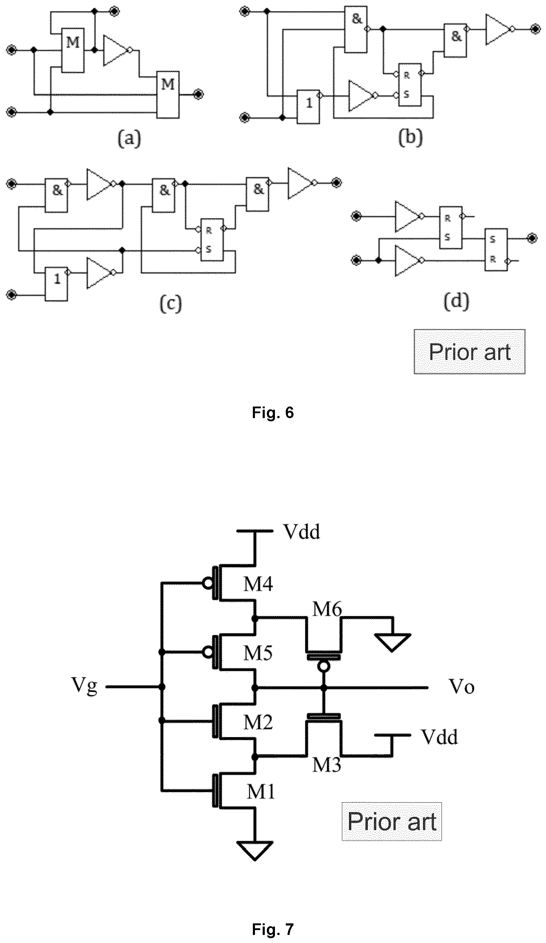

**Figure 6** shows different ways of realizing a Muller-C-element using conventional circuit technology based on silicon semiconductors with a variety of components. That is, this is prior art as shown in cited non-patent document [7].

**Figure 7** shows the realization of a Schmitt-Trigger in C-MOS technology based on conventional silicon semiconductor technology. That is, this is prior art as shown in cited non-patent document [8].

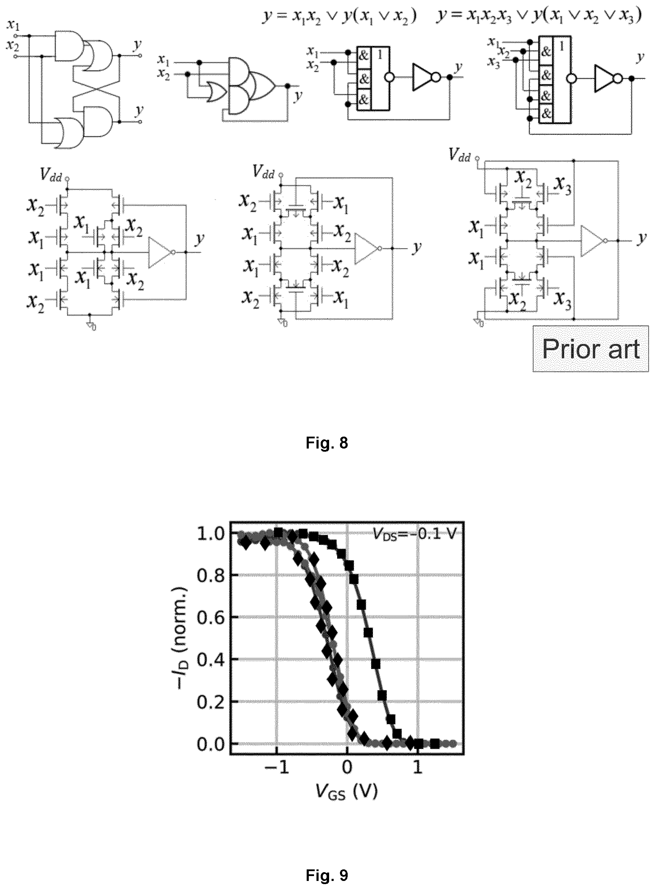

As can be seen from Figs. 6 and 8, a large number of such components are required to realize a Muller-C-element with conventional components. In contrast, with an OECT according to the invention having at least two gate electrodes, as shown by way of example in Fig.5, a Muller-C element can be realized with only a single component. On the one hand, this reduces the complexity of the circuits and thus also makes them more reliable; on the other hand, it also reduces their space requirement and power consumption.

**Figure 8** shows various Muller-C-circuits with more than one input, where the Muller-C-circuits are implemented with conventional silicon semiconductor-based devices. That is, this is prior art as shown in cited non-patent document [7].

**Figure 9** illustrates the transfer curve of an exemplary embodiment both with and without addition of $CaCl_2$ into the electrolyte.

The curve marked by squares represents the OECT according to the present invention and has a pronounced hysteresis.

The curve marked by diamonds represents an OECT according to the invention with a CaCb addition in the electrolyte of 8 %. As can be seen, the CaCb causes a suppression of the hysteresis.

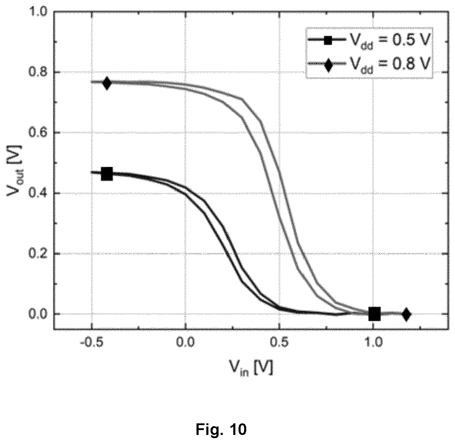

**Figure 10** illustrates two output characteristics of unipolar inverters with passive load (using a resistor). The OECTs shown were generated by additional irradiation with 365 nm UV light at a dosage of 1500 mJ/cm$^2$.

The figure illustrates the possibility of switching off the hysteresis of the OECT according to the invention and thus achieving a conventional inverter characteristic. The first characteristic curve was generated using a supply voltage (Vdd) of 0.5 V (square symbols), while the second characteristic curve was generated at a supply voltage of 0.8 V (diamond-shaped symbols).

The embodiments of the invention described in the foregoing description are examples given by way of illustration and the invention is nowise limited thereto. Any modification, variation and equivalent arrangement as well as combinations of embodiments or of some features of embodiments should be considered as being included within the scope of the invention as long as they are not mutually exclusive.

**List of reference signs**

| | |
|---|---|
| 1.0, 3.0 | OECT |
| 1.1 | Source electrode |
| 1.2 | Gate electrode |
| 1.21 | first gate electrode |
| 1.22 | second gate electrode |
| 1.3 | Channel |
| 1.31 | Organic semiconductor material |
| 1.4 | Drain electrode |
| 1.5 | Electrolyte |
| 1.6 | Cartesian coordinate system |
| 1.7 | Substrate |
| 2.0 | Bistable hysteresis curve |
| 2.1 | Operating point $M_L$ in upper branch |
| 2.2 | Falling edge of upper branch |
| 2.3 | Switching point H from upper branch to lower branch |
| 2.4 | Operating point $M_H$ in lower branch |
| 2.5 | Rising edge of lower branch |
| 2.6 | Switching point L from lower branch to upper branch |
| $d_{channel}$ | Depth of the channel |
| $d_{drain}$ | Depth of the drain electrode |
| $d_{el}$ | Depth of the electrolyte |
| $d_{gate}$ | Depth of the gate electrode |
| $d_{substrate}$ | Depth of the substrate |
| $l_{channel}$ | Length of the channel |
| $l_{drain}$ | Length of the drain electrode |
| $l_{el}$ | Length of the electrolyte |
| $l_{gate}$ | Length of the gate electrode |
| $l_{source}$ | Length of the source electrode |
| $l_{substrate}$ | Length of the substrate |
| $w_{channel}$ | Width of the channel |
| $w_{drain}$ | Width of the drain electrode |
| $w_{el}$ | Width of the electrolyte |
| $w_{gate}$ | Width of the gate electrode |
| $w_{g-ch}$, $w_{g1-ch}$, $w_{g2-ch}$ | Distance between the respective gate electrode and the channel |

| | |
|---|---|
| w$_{org}$, w$_{org1}$, w$_{org2}$ | Width of that part of the respective gate electrode which is covered by organic semiconductor material |
| w$_{source}$ | Width of the source electrode |
| w$_{substrate}$ | Width of the substrate |
| V$_{GS1}$ | Voltage between first gate electrode and source electrode |
| V$_{GS2}$ | Voltage between second gate electrode and source electrode |
| V$_{DS}$ | Voltage between drain electrode and source electrode |
| T1 | Transition point 1 |
| T2 | Transition point 2 |
| Vdd | Power supply |

## Non patent literature

[1] Perez, Jake C. und Sean E. Shaheen (Aug. 2020). "Neuromorphic-Based Boolean and Reversible Logic Circuits from Organic Electrochemical Transistors ". In: MRS Bulletin 45.8, S. 649-654. issn: 0883-7694, 1938-1425. doi: 10.1557/mrs.2020.202. url: http://link.springer.com/10.1557/mrs.2020.202 (visited on 15.05.2023).

[2] Weissbach, Anton u.a. (17. Feb. 2022). "Photopatternable Solid Electrolyte for Integrable Organic Electrochemical Transistors: Operation and Hysteresis ". In: Journal of Materials Chemistry C 10.7, S. 2656-2662. issn: 2050-7534. doi: 10.1039/D1TC04230K. url: https://pubs.rsc.org/en/content/articlelanding/2022/tc/d1tc04230k (visited on 15.05.2023).

[3] Cucchi, Matteo u.a. (5. Dez. 2021). Thermodynamics of Organic Electrochemical Transistors. doi: 10.21203/rs.3.rs-1143463/v1.

[4] Tseng, Hsin u.a. (11. Jan. 2023). Threshold Voltage Control in Dual-Gate Organic Electrochemical Transistors.

[5] Qian, Chuan u.a. (23. Feb. 2017). "Multi-Gate Organic Neuron Transistors for Spatiotemporal Information Processing ". In: Applied Physics Letters 110.8, S. 083302. issn: 0003-6951. doi: 10.1063/1.4977069. url: https://doi.org/10.1063/1.4977069 (visited on 15.05.2023).

[6] Tarabella, G. u.a. (2015). "A Hybrid Living/Organic Electrochemical Transistor Based on the Physarum Polycephalum Cell Endowed with Both Sensing and Memristive Properties ". In: Chemical Science 6.5, S. 2859-2868. doi: 10.1039/C4SC03425B. url: https://pubs.rsc.org/en/content/articlelanding/2015/sc/c4sc03425b (visited on 15.05.2023).

[7] Friedman, J.S. u.a. (2016) "Bayesian Inference with Muller C-Elements". In IEEE Transactions on circuits and Systems-I, vl. 63, 895-904. doi: 10.1109/TCSI.2016.2546064. url: https://ieeexplore.ieee.org/document/7470601

[7] C-Element (9. Jan. 2023). In: Wikipedia. url: https://en.wikipedia.org/w/index. php?title=C-element&oldid=1132505865 (visited on 15.05.2023).

[8] Schmitt-Trigger (5. Sep. 2022). In: Wikipedia. url: https://de.wikipedia.org/w/ index.php?title=Schmitt-Trigger&oldid=225913788 (visited on 15.05.2023).

## Claims

1. An electronic component comprising:

   - at least one gate electrode,
   - a source electrode,
   - a drain electrode,
   - a channel and
   - an electrolyte,

the electrolyte being a solid electrolyte comprising a polymer and the channel comprising an organic semiconductor as a channel material, **characterized in that** the electrolyte has a maximum water content of 700 %, wherein the percentage refers to the weight of the polymer contentin the electrolyte (weight percent).

2. The electronic component according to claim 1, **characterized in that** the electrolyte has a maximum C1-C3-alcohol content of 700 %, wherein the percentage refers to the weight of the polymer content in the electrolyte (weight percent).

3. The electronic component according to claim 1 or 2, **characterized in that** the electrolyte has a maximum content of halogen alkaline salts or halogen alkaline earth salts or acetate salts or combinations thereof of 10 %, wherein the percentage refers to the weight of the polymer content in the electrolyte (weight percent).

4. The electronic component according to one of the preceding claims, **characterized in that** the current-voltage characteristic has a defined bistable hysteresis, wherein:

    i. the transition points have a voltage difference of at least 60 mV, and
    ii. a slope of minimal 57 mV/dec and maximal 300 mV/dec.

5. The electronic component according to one of the preceding claims, **characterized in that** the electrolyte is a gel which contains at least one polymer and an ionic liquid.

6. The electronic component according to claim 5, **characterized in that** the electrolyte further comprises at least one additive.

7. The electronic component according to one of the preceding claims, **characterized in that** the component has at least two gate electrodes.

8. The electronic component according to claim 7, **characterized in that** the gate electrodes are located at the same distance from the channel.

9. The electronic component according to claim 7 or 8, **characterized in that** each gate electrode has a base area about 10 times the channel area.

10. The electronic component according to any one of claims 7 to 9 **characterized in that** the ratio of active base areas of the two gate electrodes is in the range 1:1 to 1:10.

11. Use of an electronic component according to one of claims 1 to 10 as a Schmitt-Trigger or a Muller-C-element or a flip-flop or a 1-bit memory.

12. Method for producing an electronic component according to any of claims 1 to 11, the method comprising the steps:

    - forming at least one gate electrode,
    - forming a source electrode,
    - forming a drain electrode,
    - forming a channel comprising an organic semiconductor as a channel material, and
    - forming an electrolyte, being a solid electrolyte comprising a polymer,

**characterized in that** the electrolyte has a maximum water content of 700 %, wherein the percentage refers to the weight of the polymer content in the electrolyte (weight percent).

13. The method according to claim 12, further comprising irradiating the electronic component with UV light.

14. The method according to claim 13, **characterized in that** the UV spectrum is in a range from 100 nm to 455 nm.

15. The method according to claim 13 or 14, **characterized in that** the dose of irradiation is at least 100 mJ /cm$^2$.

16. The method according to any of claims 13 to 15, **characterized in that** the irradiation takes place in at least two steps.

Fig. 1

**Fig. 2**

**Fig. 3**

Fig. 4

Fig. 5

(a)

(b)

(c)

(d)

Prior art

**Fig. 6**

Vdd

M4

M6

M5

Vg

Vo

M2

Vdd

M3

M1

Prior art

**Fig. 7**

$$y = x_1 x_2 \vee y(x_1 \vee x_2) \qquad y = x_1 x_2 x_3 \vee y(x_1 \vee x_2 \vee x_3)$$

Prior art

Fig. 8

Fig. 9

Fig. 10

Europäisches
Patentamt

European
Patent Office

Office européen
des brevets

# EUROPEAN SEARCH REPORT

Application Number

EP 23 19 4293

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | HSIN TSENG ET AL: "Threshold Voltage Control in Dual-Gate Organic Electrochemical Transistors", ARXIV.ORG, CORNELL UNIVERSITY LIBRARY, 201 OLIN LIBRARY CORNELL UNIVERSITY ITHACA, NY 14853, 11 January 2023 (2023-01-11), XP091413505, DOI: 10.1002/ADMI.202201914 * page 11, line first to last; figures 1,4 * | 1-16 | INV. H10K10/46 |
| X,D | WEISSBACH ANTON ET AL: "Photopatternable solid electrolyte for integrable organic electrochemical transistors: operation and hysteresis", JOURNAL OF MATERIALS CHEMISTRY C, vol. 10, no. 7, 17 February 2022 (2022-02-17), pages 2656-2662, XP093122377, GB ISSN: 2050-7526, DOI: 10.1039/D1TC04230K | 1-6,11, 12,14-16 | |
| A | * page 2657, left-hand column, paragraph – right-hand column, paragraph second; figure 1 * | 7-10 | TECHNICAL FIELDS SEARCHED (IPC) H10K |

-/--

The present search report has been drawn up for all claims

| Place of search | Date of completion of the search | Examiner |
|---|---|---|
| The Hague | 24 January 2024 | Welter, Steve |

EPO FORM 1503 03.82 (P04C01)

**page 1 of 2**

Europäisches
Patentamt

European
Patent Office

Office européen
des brevets

# EUROPEAN SEARCH REPORT

Application Number

**EP 23 19 4293**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CHEN SHUAI ET AL: "Contact Modulated Ionic Transfer Doping in All-Solid-State Organic Electrochemical Transistor for Ultra-High Sensitive Tactile Perception at Low Operating Voltage", ADVANCED FUNCTIONAL MATERIALS, vol. 30, no. 51, 28 September 2020 (2020-09-28), XP093122760, DE ISSN: 1616-301X, DOI: 10.1002/adfm.202006186 * Experimental Section page 2006186 (7 of 9); figures 1,2,4 * | 1-3,6,12 | |
| | ----- | | |
| | | | TECHNICAL FIELDS SEARCHED (IPC) |

The present search report has been drawn up for all claims

| Place of search | Date of completion of the search | Examiner |
|---|---|---|
| The Hague | 24 January 2024 | Welter, Steve |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P04C01)

**REFERENCES CITED IN THE DESCRIPTION**

**Patent documents cited in the description**

- US 20210341415 A1
- US 10424751 B2
- EP 3764092 A1

**Non-patent literature cited in the description**

- **PEREZ ; SHAHEEN**. *Organic Electrochemical Transistors for Use in Neuromorphic Computing: Boolean and Reversible Logic Gate Solutions*, 2020
- **WEISSBACH et al.** *Photopatternable solid electrolyte for integrable organic electrochemical transistors: operation and hysteresis*, 2022
- **CUCCHI et al.** *Thermodynamics of OECTs*, 2021
- **TSENG et al.** *Threshold Voltage Control in Dual-Gate Organic Electrochemical Transistors*, 2023
- **QIAN**. *Multi-gate organic neuron transistors for spatiotemporal information processing*, 2017
- **TARABELLA et al.** *A hybrid living/organic electrochemical transistor based on the Physarum polycephalum cell endowed with both sensing and memristive properties*, 2015
- **FRIEDMAN et al.** *Bayesian Inference with Muller C-Elements*, 2016
- **PEREZ, JAKE C.** ; **SEAN E. SHAHEEN**. Neuromorphic-Based Boolean and Reversible Logic Circuits from Organic Electrochemical Transistors. *MRS Bulletin*, August 2020, vol. 45 (8), ISSN 0883-7694, 1938-1425, 649-654, http://link.springer.com/10.1557/mrs.2020.202
- **WEISSBACH, ANTON**. Photopatternable Solid Electrolyte for Integrable Organic Electrochemical Transistors: Operation and Hysteresis. *Journal of Materials Chemistry C*, 17 February 2022, vol. 10 (7), ISSN 2050-7534, 2656-2662, https://pubs.rsc.org/en/content/articlelanding/2022/tc/d1tc04230k
- **CUCCHI, MATTEO**. *Thermodynamics of Organic Electrochemical Transistors*, 05 December 2021
- **TSENG, HSIN**. *Threshold Voltage Control in Dual-Gate Organic Electrochemical Transistors*, 11 January 2023
- **QIAN, CHUAN**. Multi-Gate Organic Neuron Transistors for Spatiotemporal Information Processing. *Applied Physics Letters*, 23 February 2017, vol. 110 (8), ISSN 0003-6951, 083302, https://doi.org/10.1063/1.4977069
- **TARABELLA, G.** A Hybrid Living/Organic Electrochemical Transistor Based on the Physarum Polycephalum Cell Endowed with Both Sensing and Memristive Properties. *Chemical Science*, 2015, vol. 6 (5), 2859-2868, https://pubs.rsc.org/en/content/articlelanding/2015/sc/c4sc03425b
- **FRIEDMAN, J.S.** Bayesian Inference with Muller C-Elements. *IEEE Transactions on circuits and Systems-I*, 2016, vol. 63, 895-904, https://ieeexplore.ieee.org/document/7470601
- **C-ELEMENT**. *Wikipedia*, 09 January 2023, https://en.wikipedia.org/w/index.php?title=C-element&oldid=1132505865
- **SCHMITT-TRIGGER**. *Wikipedia*, 05 September 2022, https://de.wikipedia.org/w/index.php?title=-Schmitt-Trigger&oldid=225913788